# EUROPÄISCHE PATENTSCHRIFT

(11) **EP 3 084 852 B1**
(45) Veröffentlichungstag und Bekanntmachung des Hinweises auf die Patenterteilung: **22.11.2017**
(21) Anmeldenummer: 14838779.8
(22) Anmeldetag: 04.12.2014
(51) Int. Cl.: H01L 41/09, H01L 41/083, H02N 2/00, H02N 2/02

(54) **ULTRASCHALLMOTOR**
ULTRASONIC MOTOR
MOTEUR À ULTRASONS

(30) Priorität: 18.12.2013 DE 102013226418
(43) Veröffentlichungstag der Anmeldung: 26.10.2016
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Kruspig, Volkmar
(86) Internationale Anmeldenummer: PCT/DE2014/200676
(87) Internationale Veröffentlichungsnummer: WO 2015/090312

(56) Entgegenhaltungen:
- EP-A2- 0 424 139
- WO-A2-2004/064170
- WO-A2-2011/044883

## Beschreibung

Die Erfindung betrifft einen Ultraschallmotor nach den Ansprüchen 1 bis 5.

Aus der US 6,765,335 B2 ist ein Ultraschallmotor bekannt, mit dem mittels eines Ultraschallaktors eine lineare Einkoordinatenbewegung des anzutreibenden Elements realisierbar ist. Zur Realisierung einer Zwei- oder Dreikoordinatenbewegung benötigen entsprechende Ultraschallmotoren zwei oder drei voneinander unabhängige Ultraschallaktoren (siehe hierzu beispielsweise die EP 2 258 004 B1 oder die US 7,635,940 B2). Weitere Vorrichtungen nach dem Stand der Technik sind in EP 0 424 139 A2, WO 2004 / 064170 A2 und WO 2011 / 044883 A2 beschrieben.

Aufgabe der Erfindung ist es, einen Ultraschallmotor bereitzustellen, der mittels nur eines Ultraschallaktors in der Lage ist, eine Zwei- oder Dreikoordinatenbewegung des durch ihn anzutreibenden Elements zu erzeugen.

Die Lösung der Aufgabe erfolgt durch einen Ultraschallmotor gemäß Anspruch 1, wobei die sich daran anschließenden Unteransprüche mindestens zweckmäßige Ausgestaltungen und Weiterbildungen umfassen.

Demnach wird von einem Ultraschallmotor mit einem piezoelektrischen Ultraschallaktor in Form eines Rings oder Hohlzylinders mit einer inneren Umfangsfläche, einer äußeren Umfangsfläche und zwei die innere und die äußere Umfangsfläche miteinander verbindenden ebenen Stirnflächen, wobei an einer der ebenen Stirnflächen vier Friktionselemente angeordnet sind, ausgegangen. Die Friktionselemente sind über den Umfang des Ultraschallaktors bzw. der Stirnfläche verteilt in jeweils gleichen Abständen zueinander (d.h. äquidistant) angeordnet. Mit anderen Worten liegt zwischen zwei benachbarten Friktionselementen ein Umfangswinkel von 90°, so dass sich jeweils zwei der vier Friktionselemente diametral gegenüber liegen (d.h. mit einem Umfangswinkelabstand von 180°). Die Friktionselemente stehen in Friktions- oder Wirkkontakt mit einer Friktionsfläche eines Elements, beispielsweise eines Friktionstisches, an welche sie elastisch angepresst sind.

Außerdem umfasst der erfindungsgemäße Ultraschallmotor eine elektrische Erregervorrichtung. Diese ist vorgesehen zur elektrischen Verbindung mit Erregerelektroden und allgemeinen Elektroden bzw. mit einer allgemeinen Elektrode des Ultraschallaktors, wobei die Erregerelektroden zusammen mit den allgemeinen Elektroden bzw. mit der allgemeinen Elektrode und einer zwischen der Erregerelektrode und der allgemeinen Elektrode angeordneten Schicht piezoelektrischen Materials einen Generator für eine in dem Ultraschallaktor auszubildende akustische Stehwelle bilden. Insgesamt besitzt der Ultraschallaktor zwölf gleiche und über den Umfang des Ultraschallaktors verteilte Generatoren. Jeder Generator ist Teil eines Umfangsabschnitts des Hohlzylinders bzw. Rings, wobei jeder Umfangsabschnitt einen Teilhohlzylinder bildet.

Durch entsprechende elektrische Anregung der Generatoren über die elektrische Erregervorrichtung bildet sich in dem Ultraschallaktor, der einen Wellenresonator darstellt, eine akustische Steh- bzw. Deformationswelle aus, und die durch die Stehwelle hervorgerufenen Deformationen des Ultraschallaktors führen zu entsprechenden Auslenkungen der Friktionselemente auf oder entlang einer zur Stirnfläche geneigten Bewegungsbahn und/oder einer zur Stirnfläche im Wesentlichen senkrechten Richtung (Querbewegungsbahn), wobei die geneigte Bewegungsbahn eine Längs- oder Tangentialkomponente und eine Quer- oder Axialkomponenten aufweist, und die Längs- oder Tangentialkomponente im Wesentlichen parallel zur Friktionsfläche verläuft. Hierbei kann durch die Auslenkung der Friktionselemente in der zur Stirnfläche im Wesentlichen senkrechten Richtung (d.h. auf der Querbewegungsbahn) eine Bewegung senkrecht zur Friktionsfläche (z-Richtung) generiert werden, während aufgrund der Auslenkung der Friktionselemente auf oder entlang der zur Stirnfläche geneigten Bewegungsbahn eine Bewegung entlang der Friktionsfläche (x-y-Ebene) generiert werden kann.

Damit kann der erfindungsgemäße Ultraschallmotor mit nur einem Ultraschallaktor sowohl eine Zweikoordinatenbewegung in einer Ebene (der x-y-Ebene) erzeugen, als auch eine Dreikoordinatenbewegung, bei der zusätzlich eine Bewegung senkrecht zur x-y-Ebene und damit in z-Richtung erfolgt. Hierbei ist einerseits eine Bewegung des Ultraschallaktors relativ zu der Friktionsfläche möglich; andererseits ist auch denkbar, dass der Ultraschallaktor feststeht und eine Relativbewegung des Elements, das die Friktionsfläche bildet, bewirkt.

Es kann von Vorteil sein, dass die Erregerelektroden auf der äußeren Umfangsfläche des Ultraschallaktors und die allgemeine Elektrode oder die allgemeinen Elektroden auf der inneren Umfangsfläche des Ultraschallaktors angeordnet sind.

Ebenso kann es von Vorteil sein, dass die Erregerelektroden, die allgemeinen Elektroden und die jeweils zwischen diesen angeordneten Schichten aus Piezokeramik im Wesentlichen parallel zu den Stirnflächen des Ultraschallaktors angeordnet sind.

Weiterhin kann es von Vorteil sein, dass die elektrische Erregervorrichtung eine elektrische Wechselspannung mit einer Frequenz bereitstellt, bei der im Ultraschallaktor die sechste Mode der akustischen Stehwelle erzeugt wird.

Hierbei hinaus kann es von Vorteil sein, dass der Ultraschallmotor einen Umschalter für die Elektroden enthält, der diese so mit der elektrischen Erregervorrichtung verbindet, dass bei Erzeugung der sechsten Mode der akustischen Stehwelle in dem Ultraschallaktor bei einem Paar der sich diametral gegenüberliegenden Friktionselemente die maximale Auslenkung auf oder entlang der geneigten Bewegungsbahn auftritt und bei dem anderen Paar der sich diametral gegenüberliegenden Friktionselemente die minimale Auslenkung auf oder entlang der geneigten Bewegungsbahn auftritt.

Kurze Beschreibung der Zeichnungen:
Fig. 1: Erfindungsgemäßer Ultraschallmotor (ohne Darstellung der elektrischen Erregervorrichtung)
Fig. 2: Darstellung 8: Ultraschallaktor des Ultraschallmotors gemäß Fig. 1 in perspektivischer Ansicht; Darstellung 9: Ultraschallaktor des Ultraschallmotors gemäß Fig. 1 in Draufsicht (Blickrichtung von oben)
Fig. 3: Ausführungsform eines Ultraschallaktors eines erfindungsgemäßen Ultraschallmotors (ohne Darstellung der Friktionselemente)
Fig. 4: Blockschaltbild betreffend die Verbindung des Ultrachallaktors eines erfindungsgemäßen Ultraschallmotors mit der elektrischen Erregervorrichtung
Fig. 5: Darstellung 28: FEM-Modell eines Ultraschallaktors eines erfindungsgemäßen Ultraschallmotors im unangeregten Zustand; Darstellungen 27 und 29: FEM-Berechnungen der Phasen maximaler Deformation anhand des Modells gemäß Darstellung 28
Fig. 6: Darstellungen 33 bis 38: Einfluss der unterschiedlichen elektrischen Ansteuerung eines Ultraschallaktors eines erfindungsgemäßen Ultrachallmotors auf die Auslenkungsrichtung der Friktionselemente
Fig. 7: Kontakt- bzw. Eingriffssituation zwischen einem Friktionselement eines Ultraschallaktors eines erfindungsgemäßen Ultraschallmotors und einer Friktionsfläche

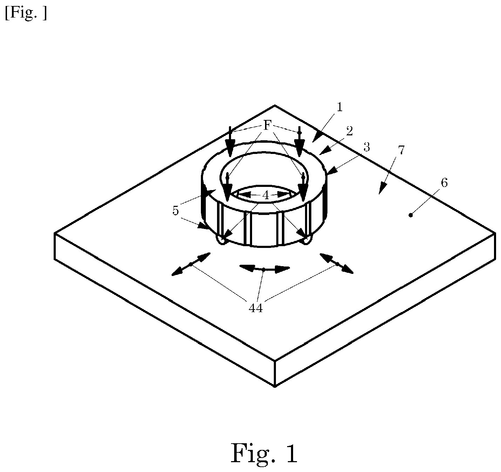

Fig. 1 zeigt einen erfindungsgemäßen Ultraschallmotor, aufweisend einen Ultraschallaktor 1, der einen Wellen-Resonator 2 bildet, wobei der Ultraschallaktor als Hohlzylinder 3 aus einem piezoelektrischen Material ausgeführt ist, und auf dessen einer ebenen Stirnfläche 5 vier Friktionselemente 4 angeordnet sind. Der Ultraschallaktor 1 ist durch eine Kraft F mit seinen Friktionselementen 4 elastisch an die Friktionsfläche 6 eines Friktionstisches 7 angepresst. Die Kraft F kann durch die Schwerkraft des Ultraschallaktors hervorgerufen sein, sie kann jedoch ebenso durch ein zusätzliches Element, beispielsweise eine Feder oder ein Magnet, hervorgerufen sein.

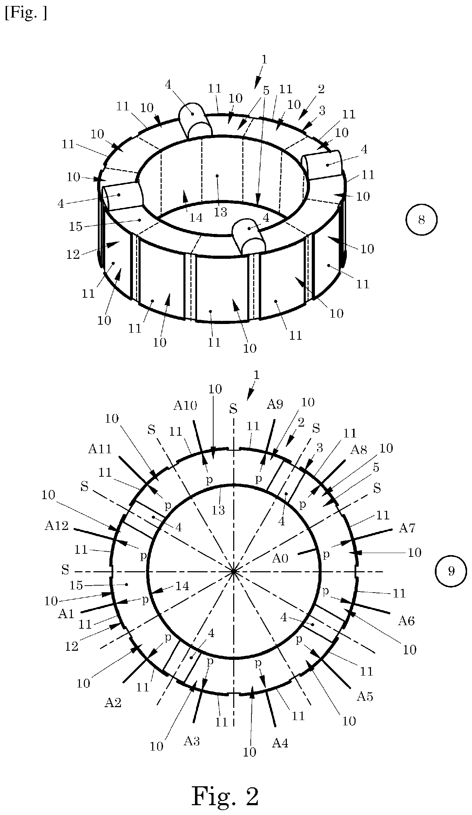

Darstellung 8 von Fig. 2 zeigt den Ultraschallaktor gemäß Fig. 1 als Einzelteil. Der Ultraschallaktor weist insgesamt zwölf gleiche Umfangsabschnitte bzw. Umfangssegmente 10 auf. Jeder Umfangsabschnitt 10 umfasst eine Erregerelektrode 11, wobei sich die Erregerelektroden benachbarter Umfangsabschnitte 10 nicht berühren. An der inneren Umfangsfläche 14 des Ultraschallaktors ist eine komplett umlaufende allgemeine Elektrode 13 angeordnet. Jede Erregerelektrode 11 bildet mit dem entsprechend gegenüberliegenden Abschnitt der allgemeinen Elektrode 13 und der zwischen beiden Elektroden angeordneten Schicht piezoelektrischen Materials einen Generator für eine in dem Ultraschallaktor auszubildende akustische Steh- oder Deformationswelle. Auf der ebenen Stirnfläche 5 sind vier Friktionselemente 4 angeordnet, wobei die Friktionselemente jeweils im Bereich der Mitte zwischen zwei benachbarten Erregerelektroden angeordnet sind. Mit anderen Worten: die Symmetrielinie jedes Friktionselements verläuft in der Mitte zwischen zwei benachbarten Erregerelektroden. Zwei benachbarte Friktionselemente 4 schließen einen Umfangswinkel von im Wesentlichen 90° ein, so dass es zwei Paare von Friktionselementen gibt, bei denen die beiden entsprechenden Friktionselemente diametral gegenüberliegend angeordnet sind.

Anhand Darstellung 9 von Fig. 2, welche den Ultraschallaktor gemäß Darstellung 8 in Draufsicht zeigt, sind die geometrischen Beziehungen zwischen den einzelnen Elementen des Ultraschallaktors besonders gut erkennbar. Durch den Zylinder bzw. den Kreis des Zylinders lassen sich zahlreiche Diametralebenen S legen (strichpunktierte Linien), die entweder jeweils durch die Mitte zwischen zwei benachbarten Erregerelektroden verlaufen, oder aber welche die Symmetrieebenen der Friktionselemente darstellen. Die Diametralebenen S teilen den Hohlzylinder in zwölf gleiche Umfangsabschnitte 10. In Darstellung 8 von Fig. 2 sowie in den entsprechenden anderen Figuren sind die Schnittpunkte der Diametralebenen S mit dem Ultraschallaktor 1 durch punktierte Linien gekennzeichnet.

Weiterhin ist anhand Darstellung 9 von Fig. 2 die Polarisationsrichtung der piezokeramischen Schicht 15 anhand entsprechender Pfeile mit dem Index p gekennzeichnet. Die Polarisationsrichtung ist hierbei normal zu den Elektroden orientiert, so dass eine radial gerichtete Polarisation resultiert. Außerdem zeigt Darstellung 9 von Fig. 2 die elektrischen Anschlüsse A1 bis A12 der Erregerelektroden bzw. den elektrischen Anschluss A0 der allgemeinen Elektrode.

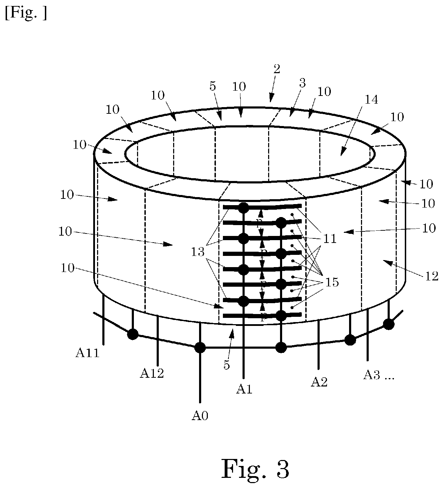

Fig. 3 zeigt eine alternative Ausführungsform für einen Ultraschallaktor eines erfindungsgemäßen Ultraschallmotors. Bei diesem liegen für jeden Generator mehrere Schichten von Erregerelektroden 11 und allgemeinen Elektroden 13 in abwechselnder Anordnung vor, wobei zwischen den Elektrodenschichten Schichten piezokeramischen Materials 15 angeordnet sind (sog. Multilayeranordnung). Die Schichten sind hierbei in axialer Richtung des Ultraschallaktors gestapelt, und die Polarisationsrichtung des piezokeramischen Materials ist normal zu den Elektroden bzw. normal zu den Stirnflächen, d.h. in Axialrichtung, wobei die Polarisationsrichtungen jeweils benachbarter Schichten piezoelektrischen Materials entgegengesetzt sind (antiparallele Polarisationsrichtung). Alle Erregerelektroden 11 des jeweiligen Generators werden durch den jeweiligen Anschluss A1 bis A12 kontaktiert, während alle allgemeinen Elektroden 13 des jeweiligen Generators über den Anschluss A0 kontaktiert sind.

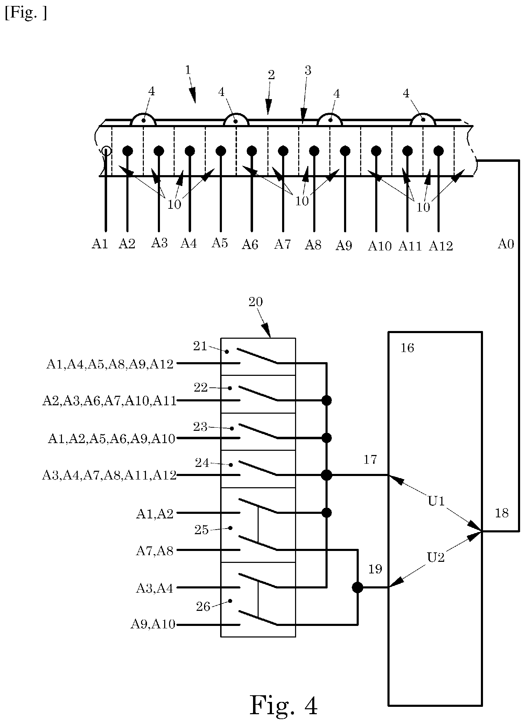

Fig. 4 zeigt ein Blockschaltbild betreffend die Verbindung des Ultraschallaktors eines erfindungsgemäßen Ultraschallmotors mit der elektrischen Erregervorrichtung 16. Die entsprechende elektrische Schaltung umfasst hierbei einen Umschalter 20, welcher die Ausschalter 21 bis 26 umfasst, mit deren Hilfe eine Verbindung zwischen der elektrischen Erregervorrichtung und den anzusteuernden Erregerelektroden realisierbar ist. Hierbei ist der Ausschalter 21 mit den Anschlüssen A1, A4, A5, A8, A9 und A12 verbunden, der Ausschalter 22 ist mit den Anschlüssen A2, A3, A6, A7, A10 und A11 verbunden usw.

Die elektrische Erregervorrichtung 16 stellt an ihren Anschlüssen 17 und 18 die elektrische Wechselspannung U1, und an den Anschlüssen 19 und 18 die elektrische Wechselspannung U2 bereit. Diese Spannungen sind zueinander um den Winkel 180° phasenverschoben. Sie haben die gleiche Frequenz fo, wodurch im Ultraschallaktor 1 die sechste Mode der akustischen Deformations-Stehwelle (sechs Halbwellen mit λ/2) angeregt bzw. erzeugt wird. Jeder der Generatoren erzeugt einen λ/4-Anteil der Stehwelle.

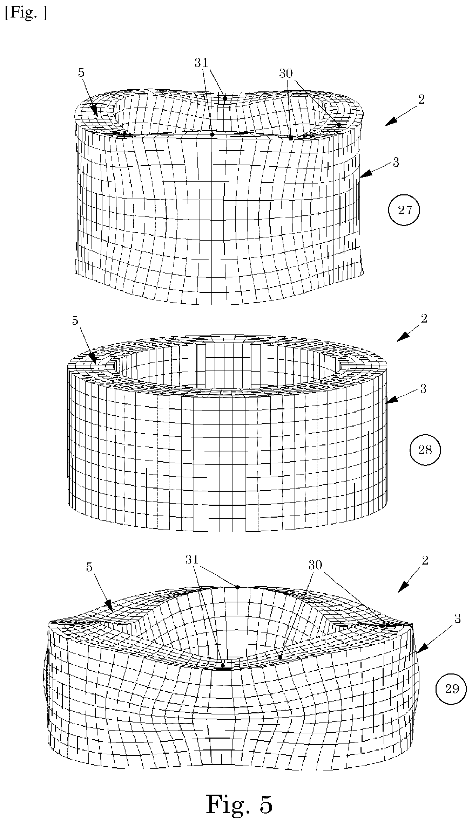

Fig. 5 zeigt in Darstellung 28 das FEM-Modell eines Ultraschallaktors eines erfindungsgemäßen Ultraschallmotors im unangeregten Zustand, während die Darstellungen 27 und 29 FEM-Berechnungen auf Basis des Modells gemäß Darstellung 28 der Phasen maximaler Deformation aufgrund der im Ultraschallaktor angeregten Stehwelle zeigen. Diese Stehwelle wird durch das Betätigen eines beliebigen Ausschalters 21 bis 26 erzeugt. Die auf den Scheiteln der Stehwelle befindlichen Punkte 30 der Stirnfläche 5 weisen nur eine Quer- bzw. Axialkomponente der Schwingungen auf. Die auf den abfallenden Abschnitten der Stehwelle liegenden Punkte 31 der Stirnfläche 5 besitzen dagegen sowohl eine Quer- bzw. Axialkomponente, als auch eine Längs- bzw. Tangentialkomponente der Schwingungen.

Das Betätigen eines beliebigen Ausschalters 21 bis 26 führt zu keiner Änderung der Form der erzeugten Stehwelle. Es ändert sich nur die Lage der Welle in Bezug zu den Friktionselementen 4. Die Verschiebung der Welle beträgt dabei entweder ein halbe Wellenlänge, d.h. λ/2, oder aber ein Viertel der Wellenlänge, d.h. λ/4.

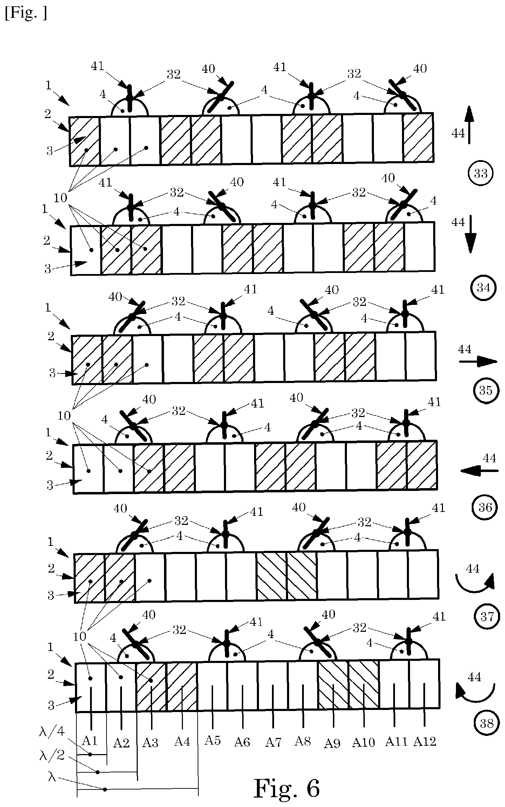

Die zuvor beschriebene Veränderung der Wellenlage hat eine Änderung der Bewegungsbahn der Punkte 32 der Friktionselemente 4 zur Folge, wie dies in den Darstellungen 33 bis 38 von Fig. 6 gezeigt ist.

Darstellung 33 entspricht hierbei der Stellung Ausschalter 21 eingeschaltet. Darstellung 34 entspricht der Stellung Ausschalter 22 eingeschaltet. Darstellung 35 entspricht der Stellung Ausschalter 23 eingeschaltet. Darstellung 36 entspricht der Stellung Ausschalter 24 eingeschaltet. Darstellung 37 entspricht der Stellung Ausschalter 25 eingeschaltet. Darstellung 38 entspricht der Stellung Ausschalter 26 eingeschaltet.

In allen Fällen bewegen sich die Punkte 32 auf zwei unterschiedlichen Bewegungsbahnen, nämlich auf der geneigten Bewegungsbahn 40 und der Querbewegungsbahn 41.

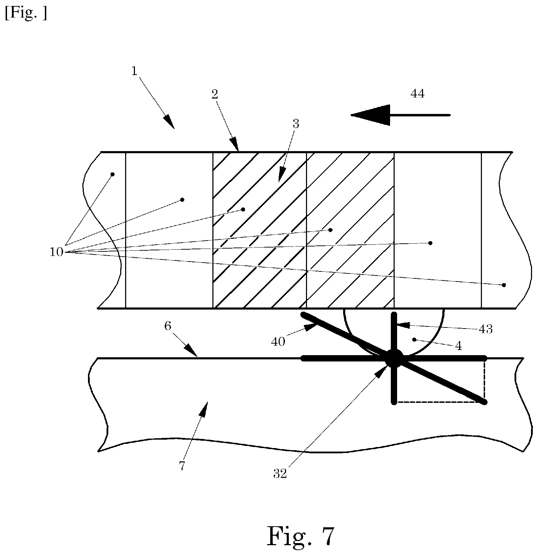

Fig. 7 verdeutlicht die Bewegung der Punkte 32 der Friktionselemente 4 auf der geneigten Bewegungsbahn 40. Die geneigte Bewegungsbahn 40 kann dabei in zwei Komponenten zerlegt werden, nämlich in eine Längs- oder Tangentialkomponente 42 und eine Quer- oder Axialkomponente 43. Die Längskomponente 42 der Bewegungsbahn bewirkt, dass das Friktionselement 5 den Aktor 1 in der mit Pfeil 44 gezeigten Richtung bewegt (Antriebsrichtung).

Die sich auf der Querbewegungsbahn 41 bewegenden Punkte 32 besitzen keine Längsbewegungskomponente, weshalb sie auch keinen Einfluss auf die Bewegung des Aktors 1 haben.

Das Betätigen der Ausschalter 21 bis 26 führt zu einer Änderung der Bewegungsbahn der Punkte 32, und zwar von einer Querbewegungsbahn 41 zu einer geneigten Bewegungsbahn 40 und zu der in den Darstellungen 33 bis 38 von Fig. 6 gezeigten Umkehr der Neigungswinkel der Bewegungsbahn 40. Diese Umkehr des Neigungswinkels der Bewegungsbahn 40 führt zu einer Bewegungsumkehr (siehe hierzu auch die in Fig. 1 mit den sechs Pfeilen 44 dargestellte Änderung der Bewegung des Aktors 1 auf dem Friktionstisch 7).

Durch das Betätigen der Ausschalter 21 bis 26 ist eine Linearbewegung des Aktors 1 auf der Friktionsfläche 6 möglich, und zwar vorwärts (gemäß Darstellung 33 von Fig. 6) rückwärts (gemäß Darstellung 34 von Fig. 6), nach rechts (gemäß Darstellung 35 von Fig. 6) und nach links (gemäß Darstellung 36 von Fig. 6). Weiterhin ist eine Drehbewegung im Uhrzeigersinn (gemäß Darstellung 37 von Fig. 6) oder entgegen dem Uhrzeigersinn (gemäß Darstellung 38 von Fig. 6) möglich.

Die Erfindung ermöglicht eine konstruktive Auslegung des Ultraschallmotors, bei dem der Ultraschallaktor 1 befestigt ist, welcher den in Führungen angeordneten Friktionstisch 7 in Bewegung versetzt, wobei die Führungen die zu den Stirnflächen 5 des Aktors 1 senkrecht verlaufenden Bewegung begrenzen (in den Fig. nicht dargestellt).

## Patentansprüche

1. Ultraschallmotor, umfassend einen piezoelektrischen Ultraschallaktor (1) mit vier daran angeordneten Friktionselementen (4), eine Friktionsfläche (6), die mit den Friktionselementen in Friktionskontakt ist, und eine elektrische Erregervorrichtung (16), wobei der Ultraschallaktor die Form eines Rings oder Hohlzylinders mit einer inneren Umfangsfläche (14), einer äußeren Umfangsfläche (12) und zwei die innere und die äußere Umfangsfläche verbindende ebene Stirnflächen (5) aufweist, wobei die vier Friktionselemente auf einer der Stirnflächen des Ultraschallaktors in bezüglich der Umfangsrichtung äquidistantem Abstand angeordnet sind, so dass sich jeweils zwei der Friktionselemente diametral gegenüber liegen, und der Ultraschallaktor zwölf gleiche Umfangsabschnitte (10) umfasst, wovon jeder einen Generator für eine in dem Ultraschallaktor auszubildende akustische Stehwelle aufweist, und jeder Generator wenigstens eine Erregerelektrode (11), wenigstens eine allgemeine Elektrode (13) oder einen Abschnitt einer allgemeinen Elektrode und eine zwischen der Erregerelektrode und der allgemeinen Elektrode oder dem Abschnitt der allgemeinen Elektrode angeordnete Schicht aus Piezokeramik (15) aufweist, **dadurch gekennzeichnet, dass** die Generatoren derart betreibbar sind, dass die durch die Stehwelle hervorgerufenen Deformationen des Ultraschallaktors zu Auslenkungen eines Paares diametral gegenüberliegender Friktionselemente auf einer zur Stirnfläche geneigten Bewegungsbahn und zu Auslenkungen des anderen Paares diametral gegenüberliegender Friktionselemente auf einer zur Stirnfläche im Wesentlichen senkrechten Bewegungsbahn führen.

2. Ultraschallmotor nach Anspruch 1, **dadurch gekennzeichnet, dass** die Erregerelektroden auf der äußeren Umfangsfläche des Ultraschallaktors und die allgemeine Elektrode oder die allgemeinen Elektroden auf der inneren Umfangsfläche des Ultraschallaktors angeordnet sind.

3. Ultraschallmotor nach Anspruch 1, **dadurch gekennzeichnet, dass** die Erregerelektroden, die allgemeinen Elektroden und die jeweils zwischen diesen angeordneten Schichten aus Piezokeramik im Wesentlichen parallel zu den Stirnflächen des Ultraschallaktors angeordnet sind.

4. Ultraschallmotor nach einem der vorhergehenden Ansprüche, **dadurch gekennzeichnet, dass** die elektrische Erregervorrichtung eine elektrische Wechselspannung mit einer Frequenz bereitstellt, bei der im Ultraschallaktor die sechste Mode der akustischen Stehwelle erzeugt wird.

5. Ultraschallmotor nach Anspruch 4, **dadurch gekennzeichnet, dass** dieser einen Umschalter (20) für die Elektroden enthält, der diese so mit der elektrischen Erregervorrichtung verbindet, dass bei Erzeugung der sechsten Mode der akustischen Stehwelle in dem Ultraschallaktor bei einem Paar der sich diametral gegenüberliegenden Friktionselemente die maximale Auslenkung entlang der geneigten Bewegungsbahn auftritt und bei dem anderen Paar der sich diametral gegenüberliegenden Friktionselemente die minimale Auslenkung entlang der geneigten Bewegungsbahn auftritt.

## Claims

1. An ultrasonic motor, comprising a piezoelectric ultrasonic actuator (1) having four friction elements (4) disposed thereon, a friction surface (6) which is in frictional contact with the friction elements, and an electrical excitation apparatus (16), wherein the ultrasonic actuator is in the shape of a ring or hollow cylinder, having an inner circumferential surface (14), an outer circumferential surface (12) and two planar end surfaces (5) connecting the inner and the outer circumferential surfaces, wherein the four friction elements are disposed on one of the end surfaces of the ultrasonic actuator so as to be spaced equidistantly with respect to the circumferential direction, such that in each case two of the friction elements lie diametrically opposite, and the ultrasonic actuator comprises twelve identical circumferential sections (10), each of which has a generator for an acoustic standing wave to be formed in the ultrasonic actuator, and each generator has at least one excitation electrode (11), at least one general electrode (13) or a section of a general electrode and a layer of piezo-ceramic material (15) disposed between the excitation electrode and the general electrode or the section of the general electrode,
**characterized in that**
the generators are operable such that the deformations of the ultrasonic actuator caused by the standing wave lead to deflections of a pair of diametrically opposite friction elements on a movement path inclined with respect to the end surface and to deflections of the other pair of diametrically opposite friction elements on a movement path substantially perpendicular to the end surface,

2. An ultrasonic motor according to claim 1, **characterized in that** the excitation electrodes are arranged on the outer circumferential surface of the ultrasonic actuator, and the general electrode or the general electrodes are arranged on the inner circumferential surface of the ultrasonic actuator.

3. An ultrasonic motor according to claim 1, **characterized in that** the excitation electrodes, the general electrodes and the respective layers of piezo-ceramic material arranged therebetween are arranged substantially parallel to the end surfaces of the ultrasonic actuator.

4. An ultrasonic motor according to one of the preceding claims, **characterized in that** the electrical excitation apparatus provides an electrical alternating voltage with a frequency at which the sixth mode of the acoustic standing wave is generated in the ultrasonic actuator.

5. An ultrasonic motor according to claim 4, **characterized in that** it comprises a changeover switch (20) for the electrodes, which connects said electrodes to the electrical excitation apparatus in such a way that upon generating the sixth mode of the acoustic standing wave in the ultrasonic actuator the maximum deflection occurs along the inclined movement part in a pair of the diametrically opposite friction elements, and the minimum deflection occurs along the inclined movement path in the other pair of the diametrically opposite friction elements.

## Revendications

1. Moteur à ultrasons, incluant un actionneur à ultrasons piézoélectrique (1) avec quatre éléments de friction (4) agencés sur celui-ci, une surface de friction (6) qui est en contact de friction avec les éléments de friction, et un dispositif d'excitation électrique (16), dans lequel l'actionneur à ultrasons présente la forme d'un anneau ou d'un cylindre creux avec une surface périphérique intérieure (14), une surface périphérique extérieure (12) et deux surfaces frontales planes (5) qui relient la surface périphérique intérieure et la surface périphérique extérieure, dans lequel les quatre éléments de friction sont agencés sur l'une des surfaces frontales de l'actionneur à ultrasons à une distance équidistante par référence à la direction périphérique, de sorte que deux des éléments de friction respectif sont situés diamétralement à l'opposé, et l'actionneur à ultrasons inclut douze portions périphériques égales (10), dont chacune comporte un générateur pour une onde stationnaire acoustique à établir dans l'actionneur à ultrasons, et chaque générateur comprend au moins une électrode d'excitation (11), au moins une électrode générale (13) ou une portion d'une électrode générale, et une couche de piézocéramique (15) agencée entre l'électrode d'excitation électrode générale ou entre l'électrode d'excitation et la portion de l'électrode générale,
**caractérisé en ce que** les générateurs peuvent être amenés à fonctionner de telle façon que les déformations de l'actionneur à ultrasons provoquées par l'onde stationnaire mènent à des déviations d'une paire d'éléments de friction diamétralement opposés sur une voie de déplacement inclinée par rapport à la surface frontale et à des déviations de l'autre paire d'éléments de friction diamétralement opposés sur une voie de déplacement sensiblement perpendiculaire à la surface frontale.

2. Moteur à ultrasons selon la revendication 1, **caractérisé en ce que** les électrodes d'excitation sont agencées sur la surface périphérique extérieure de l'actionneur à ultrasons et l'électrode générale ou les électrodes générales sont agencées sur la surface périphérique intérieure de l'actionneur à ultrasons.

3. Moteur à ultrasons selon la revendication 1, **caractérisé en ce que** les électrodes d'excitation, les électrodes générales et les couches de piézocéramique agencées respectivement entre celles-ci sont agencées sensiblement parallèles aux surfaces frontales de l'actionneur à ultrasons.

4. Moteur à ultrasons selon l'une des revendications précédentes, **caractérisé en ce que** le dispositif d'excitation électrique produit une tension alternative électrique avec une fréquence pour laquelle le sixième mode de l'onde de stationnaire acoustique est engendré dans l'actionneur à ultrasons.

5. Moteur à ultrasons selon la revendication 4, **caractérisé en ce que** celui-ci contient un inverseur (20) pour les électrodes, qui relie celles-ci au dispositif d'excitation électrique de telle façon que lorsque le sixième mode de l'onde stationnaire acoustique est engendré, dans l'actionneur à ultrasons, pour une paire des éléments de friction diamétralement opposés se produit la déviation maximum le long de la voie de déplacement inclinée et, pour l'autre paire des éléments de friction diamétralement opposés se produit la déviation minimum le long de la voie de déplacement inclinée.
